# EUROPEAN PATENT APPLICATION

(11) **EP 1 121 004 A1**
(43) Date of publication of application: **01.08.2001**
(21) Application number: 99947933.0
(22) Date of filing: 18.10.1999
(51) Int. Cl.: H05K 3/00, H05K 13/02, B65H 3/00, B65H 29/38, B65H 31/06

(54) **METHOD AND APPARATUS FOR LOADING PRINTED BOARD OR THE LIKE, AND RECEIVING METHOD AND APPARATUS**

(30) Priority: 19.10.1998 JP 29686598
(71) Applicant: Daiwa Giken Co., Ltd., Ogaki-city, Gifu-ken 503-0816 (JP)
(72) Inventor: ANDO, Masahiro, Ogaki-city, Gifu-ken 503-0816 (JP)
(74) Representative: Torggler, Paul, Dr.
(86) International application number: JP9905720
(87) International publication number: WO0024236

(57) **Abstract**

A board feeding method and a board feeding apparatus (100) are disclosed. This invention provides speedy and reliable handling and feeding of boards (W) such as printed wiring boards (60) and protection sheets (70) together onto a processing path (11) from a board rack (80). The feeding is provided in part by holding and lifting a board (W) with first vacuum means (21) to expose a lower portion of a protection sheet (70) and holding the exposed portion with second vacuum means (22). Turn arm means (30) having board receiver means (31) is also utilized. This invention further provides a board receiving method and a board receiving apparatus.

## Description

### BACKGROUND OF THE INVENTION

### Field of the Invention:

This invention generally relates to a method and an apparatus for feeding miniature plate materials or boards such as (half-finished) printed wiring boards or copper-platedboards onto an internal path for production of printed wiring boards. This invention also relates to a method and an apparatus for receiving such boards from the internal conveyor path.

### Background Art:

It is known that, in order to produce a printed wiring board, various processing steps are involved such as drilling and etching of a copper-plated board (substrate of a printed wiring board). Such processes may be provided independently of or integrally with main production lines.

Of late, printed wiring boards carry extremely fine or microstructural circuits thereon. Unfinished printed wiring boards are often very delicate physically, especially immediately after their etching or plating process. Samethings can be said with copper-plated boards which are base materials or substrates for printed wiring boards.

Processes for manufacturing printed wiring boards are generally automated where possible in order to lower manufacturing costs as much as possible as well as to improve precision. The assignee of this application developed and proposed a variety of processing steps and equipment in the past which could effectively assist in lowering manufacturing costs. For example, the assignee's Japanese Patent Publication No. 3-3400 for "Rack System for Printed Wiring Boards" discloses a rack system which can be effectively utilized to help streamline manufacturing of printed wiring boards. This rack system is provided movably between manufacturing lines or steps, carrying semimanufactured printed wiring boards without causing physical damages thereto.

This rack system is capable of carrying numerous boards in their standing position, preventing them from directly contacting one another and facilitating easy and reliable as well as very speedy feeding of the boards where required. This system is very useful for additionally automating printed wiring board manufacturing processes. However, as the printed circuits become growingly complicated and miniaturized and growing numbers of boards must be processed in limited time frames, need to use separation or protection sheets has arisen. Miniature-sized protection sheets are placed between the boards to prevent their direct contact with one another at the time of loading onto or unloading from racks. Because of the need to use protection sheets, it has become necessary to handle each board together with its (assigned) protection sheet.

The inventor of the present invention conceived an invention in the past which has matured as Japanese Patent No. 2665654 for a "Board Feeding Apparatus". This apparatus utilizes the aforementioned board rack and is capable of finally feeding half-finished printed wiring boards into manufacturing lines without protection sheets.

This board feeding apparatus comprises a first conveyor path where the rack goes in and out, a second conveyor path provided near the rear end of the first conveyor path, a conveyor device which transports boards together with protection sheets over the second conveyor path, a third conveyor path provided continually from the rear end of the second conveyor path which can move both upward and downward, a fourth conveyor path connected from the rear end of the third conveyor path which transports boards together with the protection sheets to a processing step, sensor means which can tell boards from protection sheets and generates control signals to move the third conveyor path upward or downward, and a collection box for collecting the protection sheets as they are separated and removed from the boards.

The feeding apparatus according to Japanese Patent No. 2665654 is relatively simple in structure, and is capable of reliably separating protection sheets from half-processed printed wiring boards and feeding only the boards where required. However, the inventor wanted to further improve the apparatus.

One of the improvements which the inventor sought was to "further speed up" the whole manufacturing processes among others. The inventor improved the foregoing feeding apparatus by effectively streamlining the processes for removal of the protection sheets from the boards. This speeding up is very important when time is of essence such as when a cleaning process is to be conducted on the wiring boards, where the boards are advantageously cleaned successively at extremely short intervals. The time required for the removal of protection sheets with the foregoing apparatus was considered "loss of time".

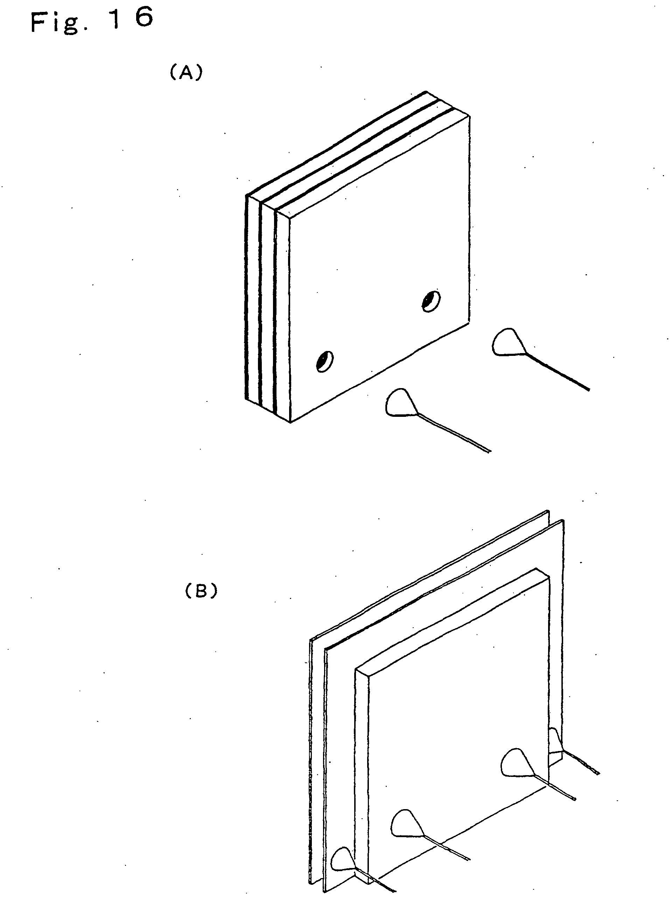

The inventor came to realize that handling a board and its assigned protection sheet as a pair provides the speed up that the inventor desired. The inventor conceived ways to handle a board and its sheet together utilizing a vacuum device. Two representative ways are briefly explained. One is shown in Fig.16(A) and another in Fig.16(B). In the exemplified embodiment shown in Fig. 16(A), a board is provided with two tiny through holes. The sheet on the rear side of the board is pneumatically attracted toward the board by vacuum powerapplied through the holes. In the exemplified embodiment shown in Fig.16(B), the sheet behind the outermost board is somewhat larger than the board, and the sheet is directly held by vacuum means as shown. However, the method shown in Fig.16(A) poses serious problems. Printed wiring boards nowadays do not afford any extra space for such through holes. In addition, preparing such through holes considerably pushes up manufacturing costs. The method shown in Fig. 16 (B) is not without a problem, either. This method requires preparation of large protection sheets, which requires "large" board feeding apparatus. As is well known, installment of "large" apparatus is great disadvantage in the relevant field.

The inventor tried hard to find ways to efficiently and reliably feed required boards without posing the problems that inevitably accompany the methods depicted in Figs.16(A) and (B) , and has finally arrived at this invention.

Accordingly, it is an object of the present invention to provide methods and apparatus that can greatly reduce board feeding and receiving times, and that reliably.

### SUMMARY OF THE INVENTION

In accordance with the present invention there is provided a method for speedily and reliably feeding boards (as defined in claim 1). An equal number of and equally sized boards and protection sheets are arranged alternately in layers on a board rack, which are held and fed in pairs (a board + a protection sheet) onto an external or internal conveyor path efficiently and reliably.

There is provided another method for speedily and reliably feeding boards (as defined in claim 2), whereby effective and reliable removal of the protection sheets from the boards is additionally provided.

A method for more reliably feeding boards (as defined in claim 3) is provided, whereby holding of a board and its assigned protection sheet together is more reliably provided with an assistance from a support means.

In accordance with the present invention, apparatuses for speedily and reliably feeding boards (as respectively defined in claims 4-6) are provided, wherein the foregoing methods are respectively utilized to provide their respective functional effects.

There are also provided a method and an apparatus for speedily and reliably receiving boards (as respectively defined in claims 7 and 8), whereby pairs of boards and protection sheets are efficiently and reliably received on a board rack one after another.

The present invention is categorized hereunder and described in more detail.

### Method of Feeding Semimanufactured Printed Wiring Boards

The present invention is more fully described using the numerals and symbols used in the accompanying drawings.

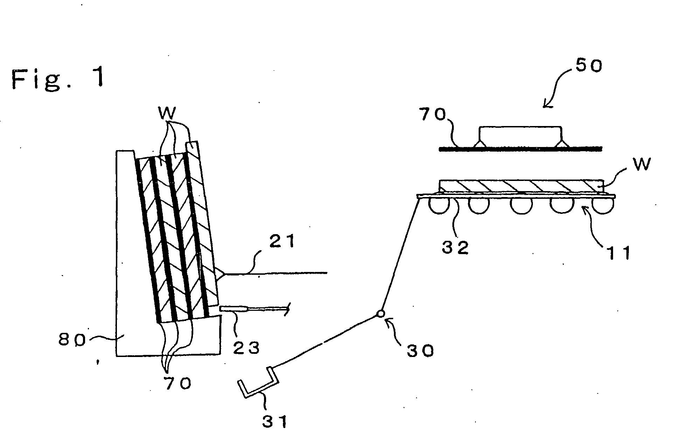

The method of claim 1 provides speedy and reliable feeding of boards (W: such as half-finished printed wiring boards 60 or copper-plated boards) with protection sheets 70 respectively covering one side of the boards together in pairs from a board rack 80 onto an internal conveyor path 11. The boards 60 and the protection sheets 70 before the feeding are arranged on the board rack 80 alternately as depicted in Fig.1.

The outermost board 60 is stuck to and picked slightly upward by first vacuum means 21 such that a lower portion of the protection sheet 70 immediately behind the board 60 is exposed. The exposed portion of the sheet 70 is utilized by and stuck to second vacuum means 22. The board 60 and the sheet 70 as stuck to the first vacuum means 21 and the second vacuum means 22 respectively are drawn onto board receiver means 31 of turn arm means 30. The turn arm means 30 may further comprise arm bed means 32.

The board receiver means 31 with the paired board 60 and sheet 70 thereon is then shifted along a circumference of an imaginary circle as the turn arm means 30 pivots toward an internal conveyor path 11. The paired board 60 and its sheet 70 are unloaded together with the arm bed means 32 (when utilized) on the internal conveyor path 11 as shown in Fig. 1.

The object of this method is to efficiently and reliably feed or unload boards (W) one after another together with their assigned protection sheets 70 in pairs onto the internal conveyor path 11 of a board feeding apparatus 100 from the board rack 80 where a number of boards (W) and protection sheets are set up alternately. The board (W) and its sheet 70 on the internal conveyor path 11 are then continually unloaded on an external conveyor path for further processing. This method can thus streamline manufacturing of printed wiring boards.

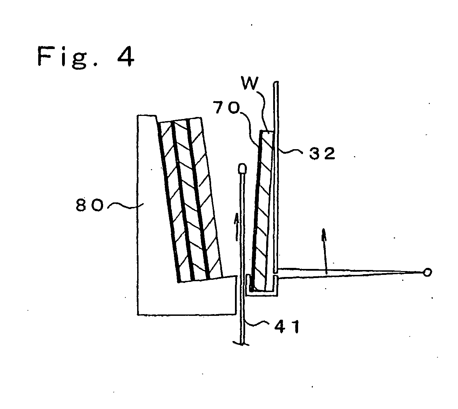

This board feeding method basically takes the steps shown in Figs.1-5. As shown in Fig.1, the first vacuum means 21 advances and sticks to the outermost board (W) on the board rack 80 and lifts the board (W) a little so as to expose a lower portion of the protection sheet 70 immediately behind the board (W).

Such a protection sheet 70 is generally 0.4-0.8mm thick and could be slightly smaller or larger than a board (W) if not identical with the board (W) in size. At any rate, a slight lift of the outermost board (W) on the board rack 80 provides exposure of a lower portion of the protection sheet 70 behind that board (W).

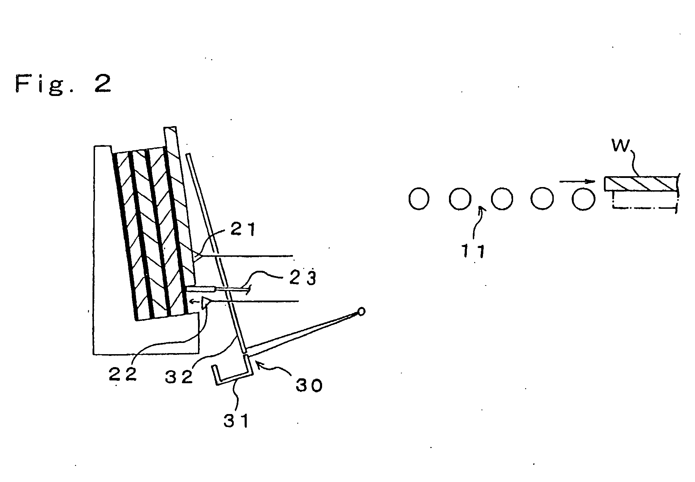

By the time the second vacuum means 22 advances and sticks to the exposed portion of the sheet 70 as shown in Fig.2, the board receiver means 31 and the arm bed means 32 are brought back in position from the internal conveyor path 11 and are ready to receive the next board (W) and its assigned protection sheet 70. The arm bed means 32 helps securely hold the board (W) and its sheet 70 which are held in the board receiver means 31 as they rest against the arm bed means 32 as shown in Fig.1. The board receiver means 31 may be provided with pneumatic means (not shown) to pneumatically and securely hold the board (W) and its sheet 70 thereon.

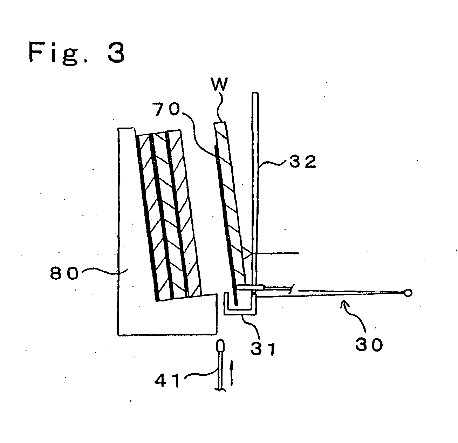

The turn arm means 30 may be additionally provided with separator means 40 having a thrusting rod 41. The separator means 40 facilitates securer holding of the board (W) and its sheet 70 on the board receiver means 31. As shown in Fig.3, the thrusting rod 41 thrusts upward behind the outermost protection sheet 70 and pushes the sheet 70 and the outermost board (W) (which may be leaning opposite from the arm bed means 32) together toward the arm bed means 32 such that the board (W) and the sheet 70 can stably rest against the arm bed means 32.

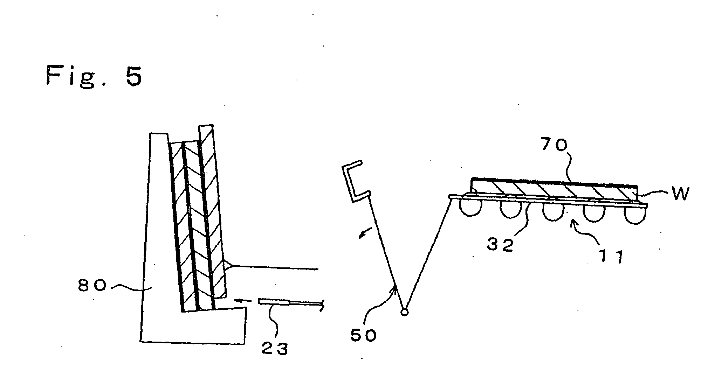

The turn arm means 30 then pivots toward the internal conveyor path 11 as shown in Fig.5 and places the arm bed means 32 onto the internal conveyor path 11 together with the paired board (W) and sheet 70, where conveyor rolls are arranged to directly support and carry away the board (W) and the sheet 70 along the internal conveyor path 11 toward an external conveyor path for further processing. The arm bed means 32 then returns to the position to receive another board (W) and its sheet 70 together from the board rack 80.

By the time the turn arm means 30 returns to the board receiving position, the first vacuum means 21 and the second vacuum means 22 will have returned to their respective vacuuming positions and started their expected work to pick the next board (W) and its sheet 70 on the board rack 80.

Thus, the boards (W) and the protection sheets 70 can be unloaded together from the board rack, while conventionally, boards and protections sheets are separately unloaded only to be combined again. The present invention can theoretically double the processing speed over such a conventional unloading method, greatly contributing to streamlining the whole manufacturing processes.

The method defined in claim 2 provides, in addition to the method of claim 1, continual feeding of boards (W) alone without their protection sheets 70 into an external conveyor path for further processing or final processing in the manufacturing lines. This method utilizes sheet remover means (sometimes referred to as "sheet placer means") 50 which removes the sheets 70 from the boards (W) as shown in Fig.5 and eventually disposes the removed sheets 70.

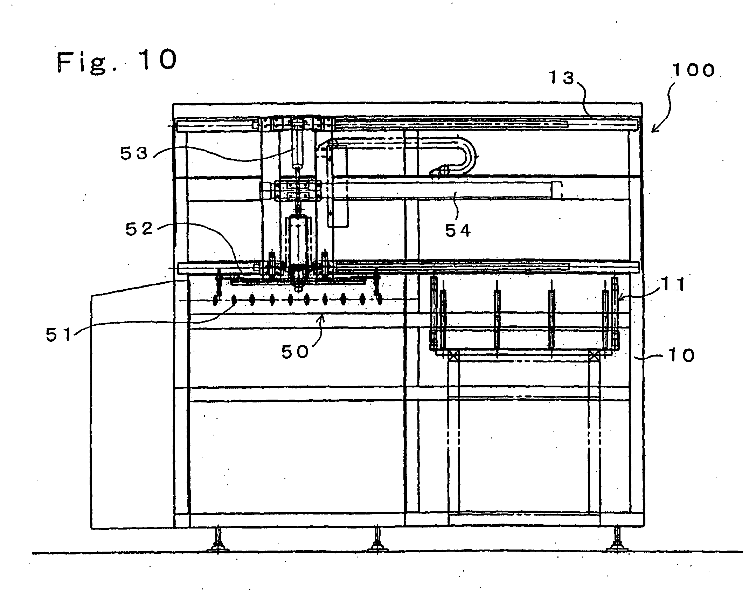

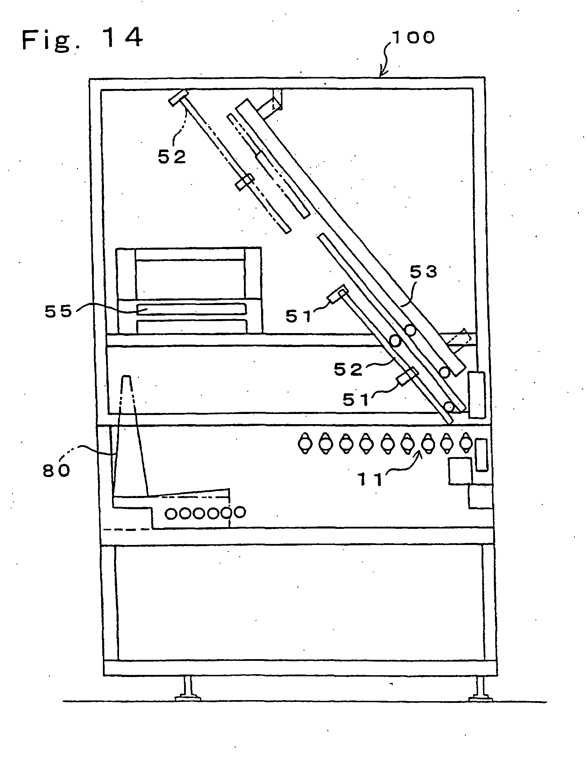

As described, this method removes and disposes the protection sheets 70 either besides the internal conveyor path 11 as shown in Fig.10 or at the starting point of the internal conveyor path 11 as shown in Fig.14. In either case, the protection sheets 70 are individually lifted from their respective boards (W) by sucking means 51 and disposed. Both sheet removal ways do not require much space.

The method defined in claim 3 further utilizes board support means 23. The board support means 23 is advanced to support the outermost board (W) from under when the board (W) is lifted by the first vacuum means 21 such that the expected function of the first vacuum means 21 will never fail.

Boards (W) such as semimanufactured printed wiring boards 60 come in various sizes and weights . Occasional and accidental vibrations or other causes may otherwise result in failure of the expected work of the first vacuum means 21. The board support means 23 prevents such failure.

### Board Feeding Apparatus 100

There is provided a board feeding apparatus 100 as defined in claim 4. This board feeding apparatus 100 carries out processes of the method according to claim 1, comprising first vacuum means 21 and second vacuum means 22, turn arm means 30 having board receiver means 31 and optionally arm bed means 32, and separator means 40 having a thrusting rod 41.

This board feeding apparatus 100 provides continual and concurrent feeding of boards (W) and their respective protection sheets 70 together in pairs into an internal conveyor path 11 and into an external conveyor path very speedily and reliably, which was not possible with conventional feeding apparatus.

There is provided another board feeding apparatus 100 as defined in claim 5. This board feeding apparatus 100 additionally comprises sheet remover means 50. The sheet remover means 50 removes the protection sheets 70 respectively from the boards (W) and disposes the removed sheets 70 so that the boards (W) without their sheets 70 are provided into main processing lines for further processing or final processing. This board feeding apparatus 100 can further shorten process times and streamline the whole manufacturing lines.

There is provided another board feeding apparatus 100 as defined in claim 6. This board feeding apparatus 100 further comprises board support means 23 in order to further reliably provide unloading or feeding of boards (W) and their protection sheets 70 regardless of the weight or size of the boards (W). The support means 23 eliminate effects from accidental physical shocks or vibrations that are generated during the board feeding operations.

### Board Receiving Method

There is provided a board receiving method as defined in claim 7. This method provides receiving of boards (W) on a board rack 80 after the boards (W) are unloaded without their respective protection sheets 70 onto an internal conveyor path 11 so that the received boards (W) may be conveyed without incurring physical damages thereto. This method comprises unloading boards (W) without protection sheets (70) onto an internal conveyor path (11) from an external conveyor path, mounting protection sheets one by one on the boards (W) in the internal conveyor path 11 and neatly mounting the paired boards (W) and sheets 70 one by one on a board rack 80 using turn arm means 30.

This method is practically the reverse of the method claimed in claim 1 except that the first vacuum means 21 and the second vacuum means 22 may advantageously function here to press each pair of a board (W) and a sheet 70 into the board rack 80. The board support means 23 may optionally be utilized.

This method provides a speedy and reliable mounting of boards (W) and protection sheets 70 in pairs on the board rack 80.

### Board Receiving Apparatus 200

There is provided a board receiving apparatus 200, which receives boards (W) without protection sheets 70 from an external conveyor path onto an internal conveyor path (11), places protection sheets 70 on the boards (W) and then unloads the pairs of boards (W) and sheets 70 on a board rack 80. The placing of the sheets 70 on the boards (W) is provided by sheet placer means 50. This sheet placer means 50 may be the sheet remover means 50 mentioned earlier. Only, the sheet placer means 50 functions in reverse of the sheet remover means 50.

The pairs of the boards (W) and the sheets 70 are mounted on the board rack 80 with the help from the first vacuum means 21 (and the second vacuum means 22) virtually in the reverse direction of the steps described earlier with board feeding.

The board receiving apparatus 200 is fundamentally the same as the board feeding apparatus 100 as claimed in claim 4. Only the steps taken by the board receiving apparatus 200 are virtually the reverse of the board feeding apparatus 100. Optionally, the support means 23 set forth may be utilized as well. The separator means 40 set forth is not required here.

The board receiving apparatus 200 is capable of efficiently and reliably receiving from an external conveyor path and unloading pairs of boards (W) and respective protection sheets 70 eventually on the board rack 80 located in a rack conveyor path.

### BRIEF DESCRIPTION OF THE DRAWINGS

FIG.1 is a partial schematic front view of a board feeding apparatus according to an embodiment of the present invention, showing how the outermost board on the board rack is held and slightly lifted upward with the first vacuum means;
FIG.2 is a partial schematic front view of the board feeding apparatus, showing a subsequent state of the board feeding process, where the arm bed means is ready to receive the next board and its protection sheet from the board rack;
FIG.3 is a partial schematic front view of the board feeding apparatus, showing how the pair of the board and its sheet is mounted on the turn arm means using the first vacuum means and the second vacuum means;
FIG.4 is a partial schematic front view of the board feeding apparatus, showing utilization of the thrusting rod;
FIG.5 is a partial schematic front view of the board feeding apparatus, showing a process state where the board receiving means is readying itself to receive another pair of a board and its sheet from the board rack;
FIG.6 is a schematic front view of the board feeding apparatus;
FIG.7 is another schematic front view of the board feeding apparatus, showing a position of the board receiver means;
FIG. 8 is a schematic plan view of the board feeding apparatus;
FIG.9 is a partial schematic enlarged left side view of the board feeding apparatus;
FIG.10 is a schematic left side view of the board feeding apparatus;
FIG. 11 is a schematic enlarged front view of the board feeding apparatus as shown in Fig.6;
FIG.12 is a schematic front view showing a sheet remover (placer) means according to an embodiment of the present invention;
FIG.13 is a schematic front view of the sheet remover means in a working state;
FIG. 14 is a schematic front view showing another type of sheet remover means;
FIG.15 is a schematic front view of a board receiving apparatus according to an embodiment of the present invention, showing an operational stage thereof;
FIGs.16 (A) and (B) are perspective views showing conventional ideas of the inventor to pick up boards and sheet pieces together in pairs, where the boards shown in Fig. 16 (A) are provided with through holes and the boards shown in Fig. 16 (B) are smaller than the protection sheets.

### BEST MODES TO CARRY OUT THE INVENTION

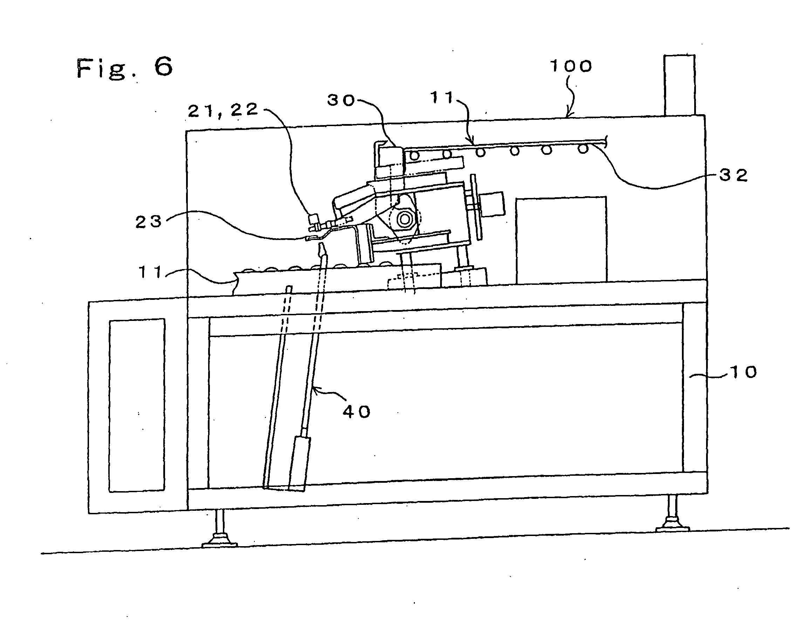

A board feeding apparatus 100 of the present invention is hereunder described in detail using the accompanying drawings. As the board feeding apparatus 100 is an embodiment selectively incorporating the methods of claims 1-3 and the apparatuses of claims 4-6, the board feeding apparatus 100 is described in connection with the embodiment depicted in Figs 6-14.

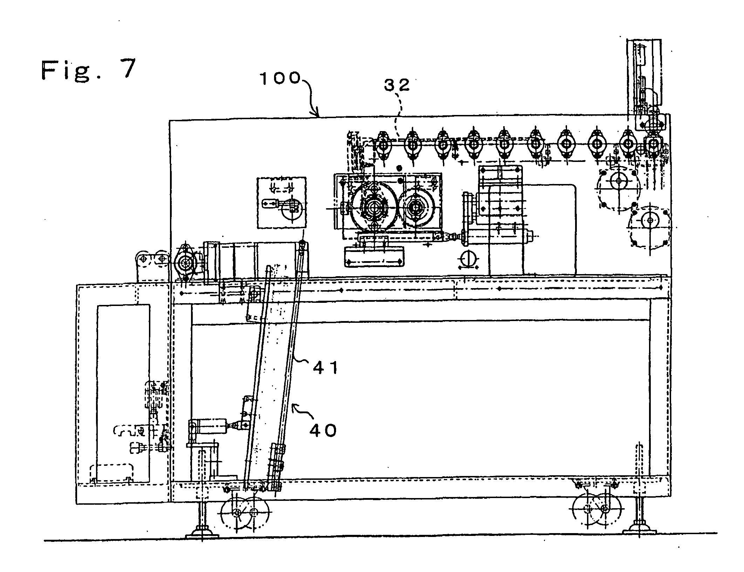

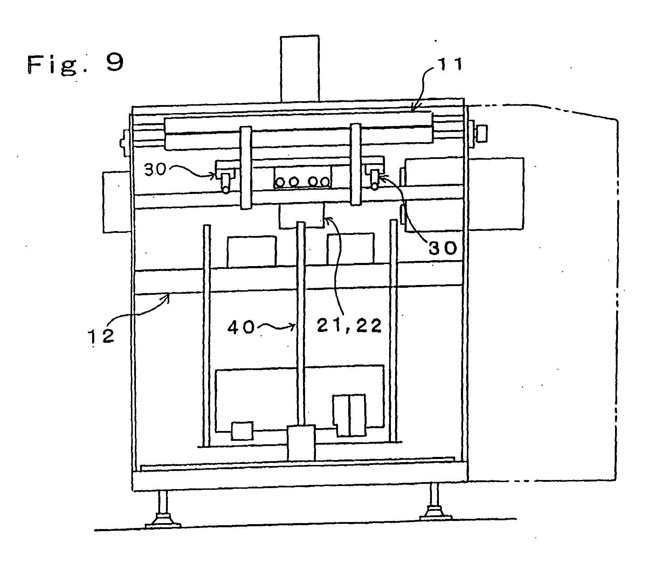

Figs.6 and 7 schematically show a front view of the board feeding apparatus 100. This board feeding apparatus 100 is installed somewhere along a printed wiring board manufacturing line. The components of the board feeding apparatus 100 are generally secured by frame means 10. The board feeding apparatus 100 receives boards (W) and their sheets 70 in pairs from a board rack 80 which enters the apparatus from left. The boards (W) and their sheets 70 are unloaded onto an internal conveyor path 11 and carried to an external conveyor path (not shown) for further processing. There is provided a rack path 12 as shown in Fig.9, where the board rack 80 enters and comes out.

The board rack 80 comprises a support portion and a back portion as shown in Figs. 1-5 and 12. Boards (W) and protection sheets 70 are mounted on the support portion of the board rack 80 alternately in their standing position, leaning against the backportion. There is provided an opening in the central portion of the support portion of the rack 80 to facilitate vertical thrusting of a thrusting rod 41 of separator means 40.

First vacuum means 21, second vacuum means 22, turn arm means 30 and the separator means 40 are installed at the front end of the rack path 12. Their movements are controlled respectively by limit switch means installed in plurality (not shown) along the apparatus 100.

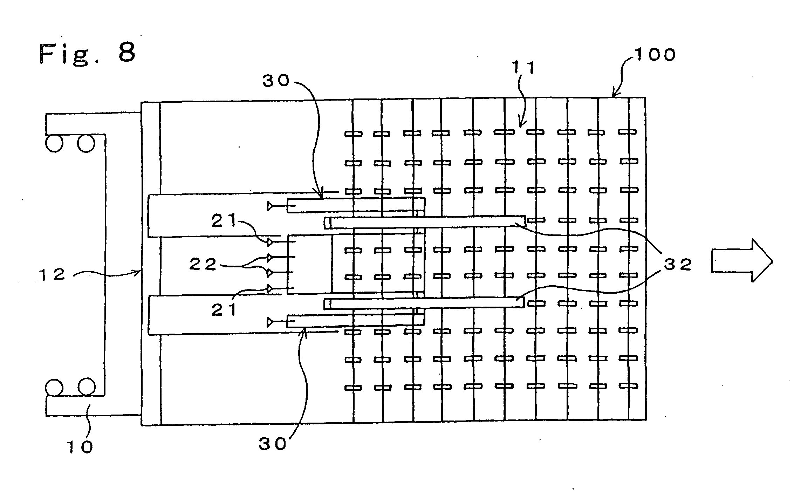

The first vacuum means 21 sticks to the outermost board (W) on the rack 80 and lifts it up a little so that a lower portion of the outermost protection sheet 70 is exposed. The second vacuum means 22 sticks to the exposed portion of the sheet 70. The first and second vacuum means 21 and 22 respectively in this embodiment have two pneumatic sticking devices as shown in Figs. 8 and 9, the sticking devices of the first vacuum means 21 flanking the sticking devices of the second vacuum means 22. These sticking devices are functionally connected to pneumatic power means (not shown). Preferably, the sticking devices are made of a soft material so as not to physically damage the boards (W).

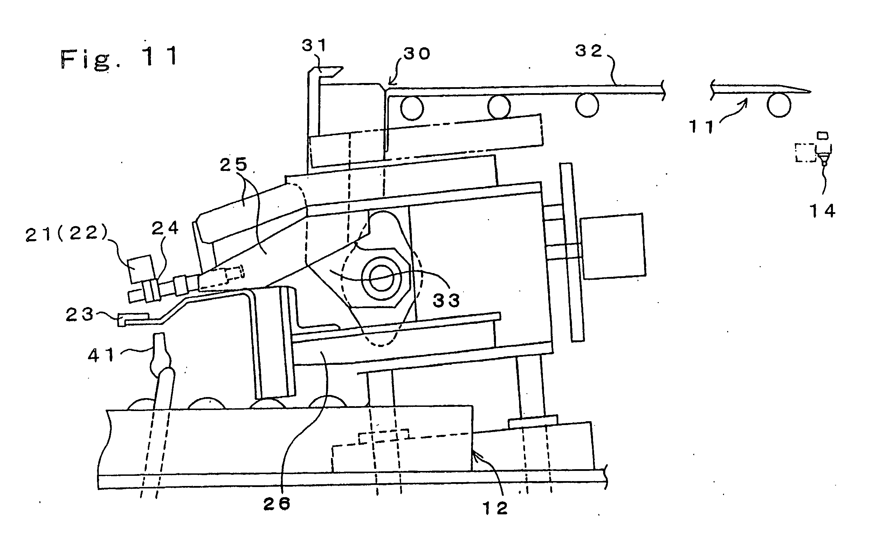

The first vacuum means 21 and the second vacuum means 22 are functionally connected to support arm means 25 such that they can move forward and backward. The lifting movement of the first vacuum means 21 is provided by lifting means 24 shown in Fig.11.

The support means 23 may be additionally provided to securely support the board (W) which is held by the first vacuum means 21. The support means 23 is especially helpful when the board (W) is relatively heavy.

The support means 23 is positioned directly below the front end of the first vacuum means 21. The support means 23 can slightly move forward and backward. The movement of the support means 23 is provided by driving means 26 such as shown in Fig. 11.

The turn arm means 30 has board receiver means 31, which is moved by swing arm means 33 shown in Fig.11. The turn arm means 30 here also includes arm bed means 32.

The turn arm means 30 facilitates speedy and reliable feeding of boards (W) together with the protection sheets 70 in pairs from the board rack 80 to an internal conveyor path 11 utilizing the first vacuum means 21 and the second vacuum means 22 and optionally the support means 23.

When a board (W) and a sheet 70 are placed together on the board receiver means 31, they are pushed toward the arm bed means 32 with the thrusting rod 41 such that the board (W) and the sheet 70 can rest stably against the arm bed means 32. The movement of the thrusting rod 41 is controlled by sensor means (not shown) which detects the placement of the board (W) and the sheet 70 on the board receiver means 31.

The paired board (W) and sheet 70 are then carried to and unloaded in the internal conveyor path 11 to be further carried to an external conveyor path (not shown) for further processing. However, when it is required to remove the protection sheet 70 from the board (W) before the pair reaches the external conveyor path, the sheet remover means 50 does the removing along the internal conveyor path 11. There are shown two types of sheet remover means 50. One is shown in Fig.10 and the other is shown in Fig.14.

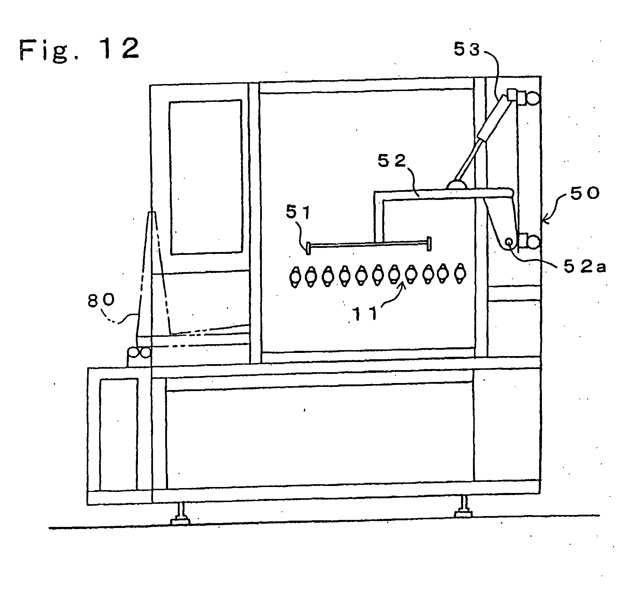

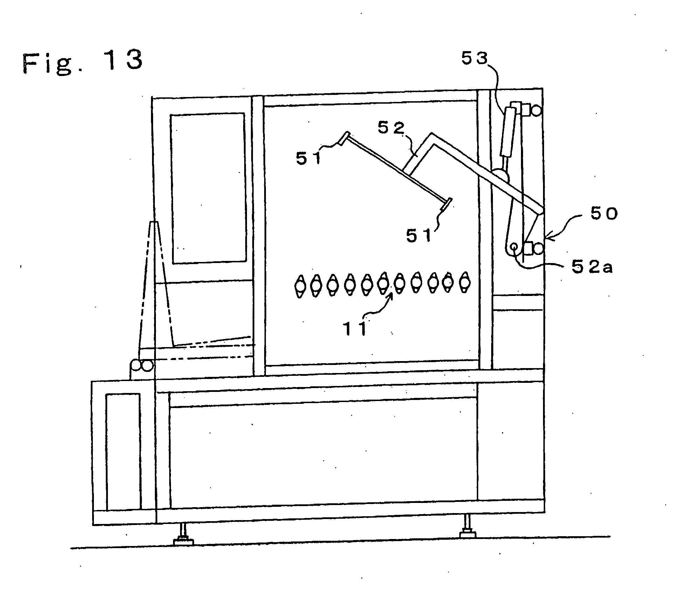

The sheet remover means 50 shown in Fig.10 provides removal of the sheet 70 from the board (W) along the internal conveyor path 11 and carries the removed sheet 70 aside for disposal. The sheet remover means 50 is provided with sheet sucking means 51 which may be functionally connected to the pneumatic power means for the first vacuum means 21. The sucking means 51 is secured to support arm means 52, which is provided on guide beam means 13 so as to move reciprocally across the internal conveyor path 11. The support arm means 52 can be inclined by piston means 53 as shown in Figs.12 and 13. The sucking means 51 can be reciprocally moved between the internal conveyor path 11 and the position shown in Fig.10.

The sheet remover means 50 shown in Fig. 14 provides removal of the protection sheet 70 from the board (W) on the internal conveyor path 11, and disposes the removed sheet 70 into a disposal box installed above the internal conveyor path 11.

Each protection sheet 70 is sucked by the sucking means 51. The support arm means 52 is lifted with the piston means 53 as shown in Fig.14. The sucking means 51 is moved together with the sheet 70 until the suckingmeans 51 comes over the disposal box 55. Then, limit switch means detects the completion of the disposal and only the board (W) (without the sheet 70) is carried along the internal conveyor path 11 and fed onto the external conveyor path (not shown).

It is important to note that while the sheet removal operation is carried on, the next board feeding onto the internal conveyor path 11 starts, which can greatly reduce the whole operation time.

There is provided a limit switch 14 along the internal conveyor path 11, which detects complete passing of the board (W) at a predetermined point and provides a signal to function the arm bed means 32.

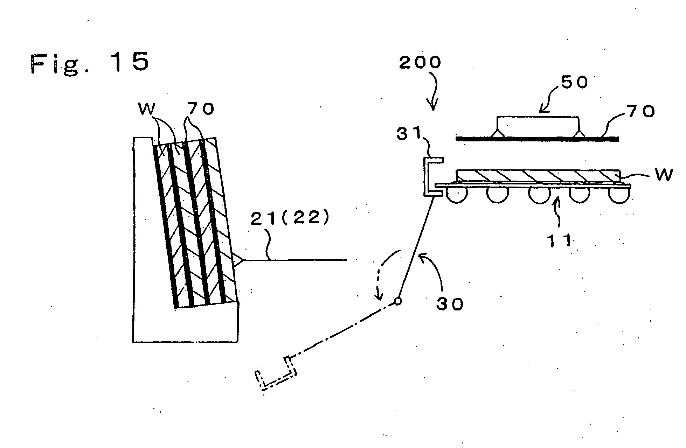

Fig.15 schematically shows the board receiving method as defined in claim 7 and the board receiving apparatus 200 as defined in claim 8. The steps of the receiving method is practically the reverse of the board feeding method described earlier. The board receiving apparatus 200 which incorporates the board receiving method functions practically in reverse of the board feeding apparatus 100.

The board receiving method and the board receiving apparatus 200 incorporating the board receiving method provide unloading of the boards (W) together with their protection sheets 70 on the board rack 80 from the internal conveyor path 11.

The board receiving apparatus 200 also has sheet placer means 50 to place protection sheets 70 respectively on boards (W) along the internal conveyor path 11 as shown in Fig. 15. The sheet placer means 50 is virtually identical with the board remover means 50 set forth earlier.

A pair of a board (W) and a sheet 70 is carried onto the board receiver means 31 together with the arm bed means 32, and then the turn arm means 30 is pivoted so that the board receiver means 31 gets ready to pass on the board (W) and the sheet 70 onto the board rack 80 utilizing the vacuum means 21(22) as a push device as shown in Fig.15.

Before utilization of the push device 21(22), an upper portion of the paired board (W) and sheet 70 will be pressed against the back portion of the board rack 80 helped by pivotal kinetic power provided to the board (W) and the sheet 70 as they are kinetically mounted on the board rack 80. Therefore, the push device 21 (22) only pushes a lower portion of the board (W) and the sheet 70. The rack 80 may be provided with an opening (not shown) so that the board receiver means 31 does not contact the rack 80 in operation.

As explained, in order to stably and neatly mount the boards (W) and sheets 70 on the rack 80 alternately, the push device 21(22) is utilized, when no vacuum power is required as will be readily appreciated by the readers.

The board receiving apparatus 200 provides efficient and reliable loading or unloading of the boards (W) and protection sheets 70 together in pairs on the board rack 80.

### INDUSTRIAL UTILIZATION

The board feeding method defined in claim 1 provides reliable and speedy feeding of paired boards and protection sheets onto an internal conveyor path, greatly reducing the process time.

The board feeding method defined in claim 2 additionally provides reliable and speedy removal of protection sheets, further reducing the process time.

The board feeding method of claim 3 provides reliable feeding of paired boards and protection sheets even when boards are relatively heavy.

The board feeding apparatus of claims 4-6 utilize the methods of claims 1-3 and provide reliable and speedy feeding of paired boards and protection sheets.

The board receiving method of claim 7 and apparatus of claim 8 provide reliable and speedy loading of paired boards and protection sheets onto a board rack or board racks, greatly reducing the process time.

## Claims

1. A board feeding method for continually feeding boards (W) such as half-finished printed wiring boards (60) or copper-plated substrate boards together with protection sheets (70) in pairs onto an internal conveyor path (11) from a board rack (80), where said boards (W) and said protection sheets (70) are alternately mounted, the paired boards (W) and protection sheets (70) to be continually unloaded from said internal conveyor path (11) onto an external conveyor path for further processing, comprising the steps:
holding and lifting the outermost board (W) on said board rack (80) with first vacuum means (21) such that a lower portion of the protection sheet (70) immediately behind said board (W) is exposed;
holding said exposed portion of said protection sheet (70) with second vacuum means (22);
drawing said outermost board (W) and said protection sheet (70) together onto board receiver means (31) of turn arm means (30);
bringing said board receiver means (31) together with said board (W) and said protection sheet (70) to an end portion of said first conveyor path (11) by pivoting said turn arm means (30); and
feeding said board (W) and said protection sheet (70) together onto said first conveyor path (11).

2. A board feeding method for continually feeding boards (W) such as half-finished printed wiring boards (60) or copper-plated substrate boards together with protection sheets (70) in pairs onto an internal conveyor path (11) from a board rack (80), where said boards (W) and said protection sheets (70) are alternately mounted, and subsequently continually unloading said boards (W) without said protection sheets (70) onto an external conveyor path for further processing, comprising the steps:
holding and lifting the outermost board (W) on said board rack (80) with first vacuum means (21) such that a lower portion of the protection sheet (70) immediately behind said board (W) is exposed;
holding said exposed portion of said protection sheet (70) with second vacuum means (22);
drawing said outermost board (W) and said protection sheet (70) together onto board receiver means (31) of turn arm means (30);
bringing said board receiver means (31) together with said board (W) and said protection sheet (70) to an end portion of said first conveyor path (11) by pivoting said turn arm means (30) ;
feeding said board (W) and said protection sheet (70) together onto said first conveyor path (11);
removing said protection sheet (70) from said board (W) with sheet remover means (50) along said first conveyor path (11); and
unloading said board (W) onto said external conveyor path without said protection sheet (70).

3. A board feeding method according to claim 1 or 2, further comprising the step:
supporting said outermost board (W) from under with support means (23) after said board (W) is lifted with said first vacuum means (21).

4. A board feeding apparatus (100) for continually feeding boards (W) such as half-finished printed wiring boards (60) or copper-plated substrate boards together with protection sheets (70) in pairs onto an internal conveyor path (11) from a board rack (80), where said boards (W) and said protection sheets (70) are alternately mounted, the paired boards (W) and protection sheets (70) to be continually unloaded from said internal conveyor path (11) onto an external conveyor path for further processing, comprising:
first vacuum means (21) to hold and lift the outermost board (W) on said board rack (80) such that a lower portion of the protection sheet (70) immediately behind said board (W) is exposed;
second vacuum means (22) to hold said exposed portion of said protection sheet (70); and
turn arm means (30) including board receiver means (31) to receive said outermost board (W) and said protection sheet (70) and feed said outermost board (W) and said protection sheet (70) together onto said internal conveyor path (11) by pivoting itself and bringing said board receiver means (31) together with said board (W) and said protection sheet (70) to an end portion of said internal conveyor path (11).

5. A board feeding apparatus (100) for continually feeding boards (W) such as half-finished printed wiring boards (60) or copper-plated substrate boards together with protection sheets (70) in pairs onto an internal conveyor path (11) from a board rack (80), where said boards (W) and said protection sheets (70) are alternately mounted, and subsequently continually unloading said boards (W) without said protection sheets (70) onto an external conveyor path for further processing, comprising:
first vacuum means (21) to hold and lift the outermost board (W) on said board rack (80) such that a lower portion of the protection sheet (70) immediately behind said board (W) is exposed;
second vacuum means (22) to hold said exposed portion of said protection sheet (70);
turn arm means (30) including board receiver means (31) to receive said outermost board (W) and said protection sheet (70) and feed said outermost board (W) and said protection sheet (70) together onto said internal conveyor path (11) by pivoting itself and bringing said board receiver means (31) together with said board (W) and said protection sheet (70) to an end portion of said internal conveyor path (11); and
sheet remover means (50) to remove said protection sheet (70) from said board (W) along said first conveyor path (11);
said internal conveyor path (11) conveying only said board (W) without said protection sheet (70) and unloading said board (W) onto said external conveyor path.

6. A board feeding apparatus (100) according to claim 4 or 5, further comprising:
support means (23) to support said outermost board (W) from under after said board (W) is lifted with said first vacuum means (21).

7. Aboard receiving method for continually receiving boards (W) such as half-finished printed wiring boards (60) or copper-plated substrate boards together with protection sheets (70) in pairs eventually onto a board rack (80), comprising the steps:
receiving a board (W) without a protection sheet (70) at a time from an external conveyor path onto an internal conveyor path (11);
placing a protection sheet (70) on said board (W) along said internal conveyor path (11);
feeding the paired board (W) and protection sheet (70) onto board receiver means (31) of turn arm means (30);
bringing said board receiving means (31) close to a board rack (80) together with said paired board (W) and protection sheet (70) by pivoting said turn arm means (30);
unloading said paired board (W) and protection sheet (70) onto said board rack (80); and
pushing said paired board (W) and protection sheet (70) so that said paired board (W) and protection sheet (70) may rest on said board rack (80).

8. A board receiving apparatus for continually receiving boards (W) such as half-finished printed wiring boards (60) or copper-plated substrate boards together with protection sheets (70) in pairs eventually onto a board rack (80), comprising:
sheet placer means (50) to place a protection sheet (70) on a board (W) at a time along an internal conveyor path (11);
turn arm means (30) including board receiver means (31) to receive the paired board (W) and protection sheet (70) onto said board receiver means (31) and bring said board receiver means (31) close to a board rack (80) together with said paired board (W) and protection sheet (70) by pivoting itself and unloading said paired board (W) and protection sheet (70) onto said board rack (80); and
pushing means to push said paired board (W) and protection sheet (70) so that said paired board (W) and protection sheet (70) may rest on said board rack (80).
